# EUROPEAN PATENT APPLICATION

(11) **EP 4 845 182 A1**
(43) Date of publication of application: **25.11.2026**
(21) Application number: 26176788.3
(22) Date of filing: 06.05.2026
(51) Int. Cl.: H04R 3/12, H03M 3/00, H04R 1/40, H04S 7/00

(54) **AUDIO PROCESSING APPARATUS**

(30) Priority: 23.05.2025 JP 2025086735
(71) Applicant: Alps Alpine Co., Ltd., Ota-ku, Tokyo 145-8501 (JP)
(72) Inventor: Sonobe, Takeru, Tokyo (JP)
(74) Representative: Schmitt-Nilson Schraud Waibel Wohlfrom Patentanwälte Partnerschaft mbB

(57) **Abstract**

An audio processing apparatus includes a signal modulator configured to perform modulation and multiplexing only on a subset of audio signals of a plurality of channels generated in one-to-one correspondence with a plurality of speakers arranged in an array, one or more channels among the plurality of channels carrying identical audio signals, the subset of the audio signals including audio signals of only a subset of the one or more channels, and the multiplexing using predetermined code information, and a drive signal generator configured to generate drive signals for driving the plurality of speakers corresponding to the plurality of channels including the subset of the one or more channels and remaining channels, based on the predetermined code information and multiplexed modulated audio signals generated from the subset of the audio signals by the signal modulator.

## Description

The present application is based on and claims priority to Japanese patent application No. 2025-086735 filed on May 23, 2025, with the Japan Patent Office.

The disclosures herein relate to audio processing apparatuses.

In recent years, a technology called immersive sound or immersive audio has attracted attention. Immersive sound is an acoustic technology that can give a sense of presence and immersion as if the listener is in a place where a sound source is present by generating three-dimensional sound or 3D surround sound in which sound is heard from all directions of the listener. While conventional surround sound expands a sound field in a planar manner, immersive sound can expand a sound field in a three-dimensional manner.

One of the technologies used in immersive sound is called wavefront synthesis. Wavefront synthesis is a technology that physically reproduces the wavefront of sound using a large number of speakers. In other words, it is possible to localize a realistic sound image similar to an actual sound source at the listener's position by outputting sound with appropriate amplitude and phase from each speaker. However, since it is necessary to individually control the sound output from a large number of speakers, a problem arises in that the number of signal lines increases and the scale of the driving circuit becomes large.

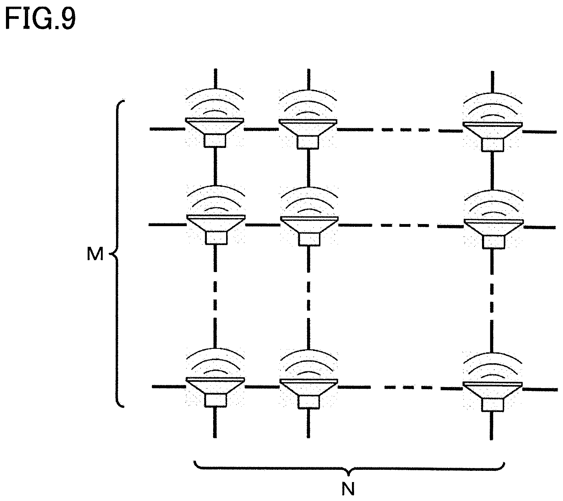

Additionally, in ΔΣ modulators widely used for quantizing acoustic signals, a technology has been proposed in which a common quantizer is used for a plurality of modulated signals and modulation and multiplexing are performed so as to obtain desired signals on respective signal lines while using a common signal line (multi-input ΔΣ modulation: MIDS), thereby enabling a large number of speakers to be individually driven. For example, when audio is output from an array of speakers arranged in an M-by-N matrix as shown in FIG. 9, the (M × N) speakers can be individually driven using M vertical signal lines and N horizontal signal lines. Using this technology, it is possible to greatly reduce the number of signal lines in a speaker array configuration and to reduce the scale of a driving circuit.

However, in MIDS, a problem arises in that the S/N ratio deteriorates as the number of speakers (number of channels) driven by a common line increases.

That is, in ΔΣ modulation, quantization noise is generated when an analog signal is converted into a digital signal, and the influence of the quantization noise is superimposed when there are a plurality of channels, and the noise floor increases. In addition, in MIDS, since audio signals of a plurality of channels are handled with a single quantizer, interference or phase shift between signals may lead to an increase in the noise floor. The S/N ratio deteriorates due to such an increase in the noise floor.

In addition, since audio signals of a plurality of channels are handled by one quantizer, the dynamic range of individual audio signals is limited, and the effective input amplitude becomes small. When the effective input amplitude is small, it becomes easy to be buried in the noise floor raised by multichannel conversion, and the relative influence of quantization noise increases. This also causes deterioration of S/N ratio.

Patent Literature (PTL) 1 discloses an array speaker driving device and an acoustic system capable of efficiently supplying power to speakers with a small number of components. The array speaker driving device disclosed in Patent Document 1 is provided with an adder that obtains the average of instantaneous values of a plurality of input signals corresponding to each of a plurality of speakers and generates an average signal of the plurality of signals based on the average, a phase inverter that inverts the phase of the average signal generated by the adder, an amplifier that amplifies the average signal whose phase is inverted by the phase inverter, a plurality of adders that add the average signal whose phase is inverted to each of the plurality of input signals, and a plurality of amplifiers that amplify the plurality of signals output by the plurality of adders.

The present disclosure aims to solve the above-described problems and improve the S/N ratio while reducing an increase in the number of signal lines and a circuit scale in a speaker array configuration.

### CITATION LIST

PATENT LITERATURE

| | |
|---|---|
| [PTL 1] | Japanese Laid-Open Patent Publication No. 2012-004655 |

The present disclosure relates to an audio processing apparatus according to the appended claims. Embodiments are disclosed in the dependent claims.

An audio processing apparatus according to an aspect includes a signal modulator configured to perform modulation and multiplexing only on a subset of audio signals of a plurality of channels generated in one-to-one correspondence with a plurality of speakers arranged in an array, one or more channels among the plurality of channels carrying identical audio signals, the subset of the audio signals including audio signals of only a subset of the one or more channels, and the multiplexing using predetermined code information, and a drive signal generator configured to generate drive signals for driving the plurality of speakers corresponding to the plurality of channels including the subset of the one or more channels and remaining channels, based on the predetermined code information and multiplexed modulated audio signals generated from the subset of the audio signals by the signal modulator.

According to the present disclosure having the above-described configuration, it is possible to reduce an increase in the number of signal lines and the circuit scale in the speaker array configuration by performing modulation and multiplexing on the audio signals of the plurality of channels using predetermined code information. Furthermore, by performing modulation with a reduced number of channels and then restoring the original number of channels to generate drive signals for a plurality of speakers, an increase in the noise floor and a decrease in effective input amplitude due to multi-channel operation can be reduced, thereby improving the S/N ratio.

### BRIEF DESCRIPTION OF THE DRAWINGS

FIG. 1 is a drawing illustrating a configuration example of an audio processing apparatus according to an embodiment;
FIG. 2 is a schematic diagram simply illustrating a principle of audio reproduction using multi-input ΔΣ modulation;
FIG. 3 is a drawing illustrating an example of speakers outputting the same audio signal;
FIG. 4 is a drawing illustrating a configuration example of a signal modulator according to an embodiment;
FIG. 5 is a drawing illustrating an example of drive signals for the speakers arranged in a line array;
FIG. 6A is a drawing illustrating an example of drive signals for speakers arranged in a two-dimensional array;
FIG. 6B is a drawing illustrating another example of the drive signals for the speakers arranged in a two-dimensional array;
FIG. 7 is a drawing illustrating another example of the drive signals for the speakers arranged in a two-dimensional array;
FIG. 8 is a drawing illustrating another example of the drive signals for the speakers arranged in a two-dimensional array; and
FIG. 9 is a drawing illustrating an example of array speakers connected to common lines.

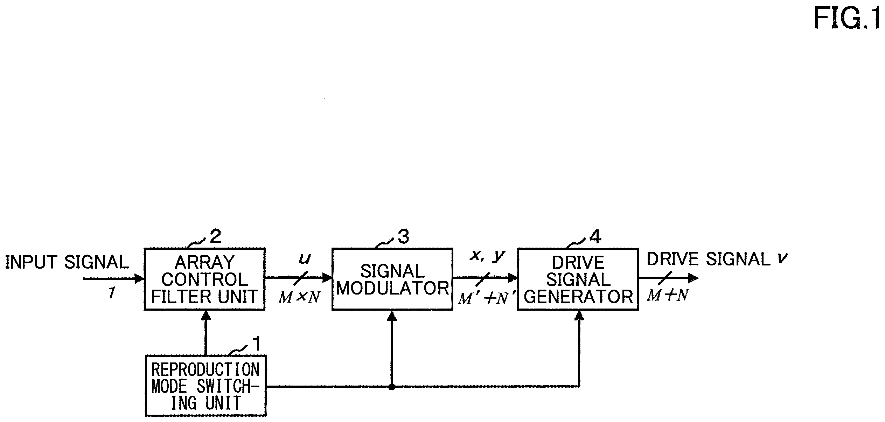

In the following, embodiments of the present invention will be described with reference to the accompanying drawings. FIG. 1 is a drawing illustrating a configuration example of an audio processing apparatus according to an embodiment. As shown in FIG. 1, the audio processing apparatus includes a reproduction mode switching unit 1, an array control filter unit 2, a signal modulator 3, and a drive signal generator 4. The signal modulator 3 is an electronic circuit (including processor) such as a CPU, a GPU, a DSP, an FPGA, and an ASIC, which executes various processing described in the present disclosure by executing instruction codes stored in a memory or by designing a circuit for a special application.

The reproduction mode switching unit 1 switches a reproduction mode for audio reproduced by a plurality of speakers arranged in a line or matrix array. A plurality of types of reproduction modes are prepared in accordance with the arrangement of the speakers targeted for audio output and the type and arrangement of virtual sound sources, and one of the reproduction modes is selected and set. The reproduction mode can be switched, for example, by a manual operation by a user. Alternatively, for example, the reproduction mode may be automatically switched in accordance with the sound source targeted for reproduction in the audio reproduction apparatus incorporating or connected to the audio processing apparatus of the present embodiment.

The array control filter unit 2 generates a plurality of array control signals u for driving a plurality of speakers arranged in an array based on an input audio signal. In the example shown in FIG. 1, the array control filter unit 2 generates (M × N) array control signals u for driving a total of (M × N) speakers (M ≥ 1, N ≥ 1, where (M, N) ≠ (1, 1)) arranged in an array of M in a first direction and N in a second direction from one input audio signal. In the following description, the term a plurality of channels refers to (M × N) channels.

The array control signals u are audio signals optimized for each speaker, which are generated by filtering the input audio signal with a spatial filter whose filter coefficients are appropriately set in terms of amplitude, phase, delay, pass frequency band, and the like based on the arrangement of the virtual sound sources and the speakers. The filter coefficients of the array control filter unit 2 are updated according to the reproduction mode set by the reproduction mode switching unit 1.

The signal modulator 3 performs modulation and multiplexing on audio signals (array control signal u) of a plurality of channels generated by the array control filter unit 2 in one-to-one correspondence with a plurality of speakers using predetermined code information. The modulation performed in the present embodiment is multi-input ΔΣ modulation (MIDS). In this case, the predetermined code information is a spreading code.

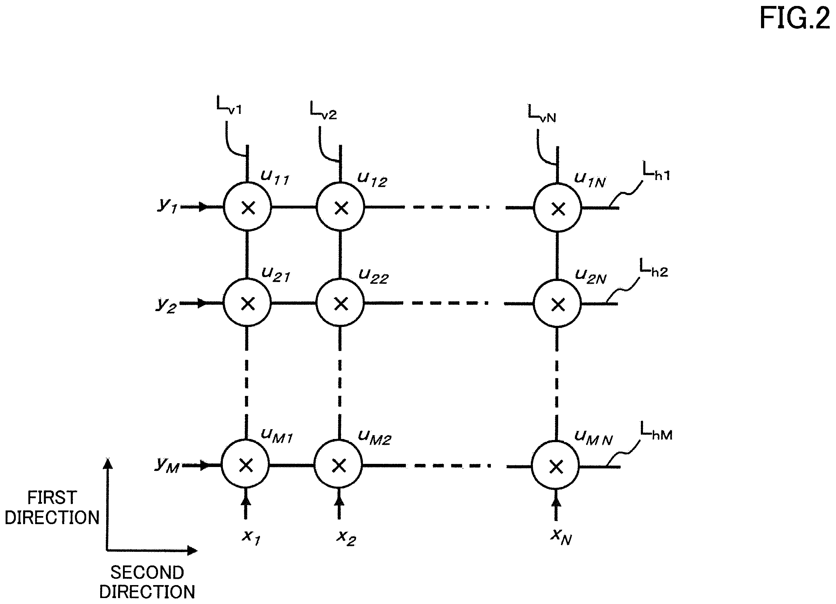

FIG. 2 is a schematic diagram simply illustrating a principle of audio reproduction using multi-input ΔΣ modulation. In the example shown in FIG. 2, with respect to M speakers in a first direction (hereinafter also referred to as a vertical direction or a column) and N speakers in a second direction (hereinafter also referred to as a horizontal direction or a row), a total of (M × N) speakers are arranged in a matrix. The signals u₁₁ to u_{MN} shown at intersections of the matrix are (M × N) array control signals u generated by the array control filter unit 2 and corresponding to the (M × N) speakers.

The N speakers in a first row are connected via a horizontal signal line Lₕ₁. The N speakers in a second row are connected via a horizontal signal line Lₕ₂. Similarly, the N speakers in an M-th row are connected via a horizontal signal line L_{hM}. The M speakers in a first column are connected via a vertical signal line Lᵥ₁. The M speakers in a second column are connected via a vertical signal line Lᵥ₂. Similarly, the M speakers in an N-th column are connected via a vertical signal line L_{vN}. That is, the (M × N) speakers are provided with M signal lines in the vertical direction and N signal lines in the horizontal direction, which is (M + N) signal lines in total.

The signal modulator 3 generates a first multiplexed modulated audio signal y₁ by applying ΔΣ modulation to the N array control signals u₁₁ to u_{1N} and performing code division multiplexing using spreading codes x₁ to x_{N}. The signal modulator 3 generates a second multiplexed modulated audio signal y₂ by applying ΔΣ modulation to N array control signals u₂₁ to u_{2N} and performing code division multiplexing using the spreading codes x₁ to x_{N}. Similarly, the signal modulator 3 generates an M-th multiplexed modulated audio signal y_{M} by applying ΔΣ modulation to N array control signals u_{M1} to u_{MN} and performing code division multiplexing using the spreading codes x₁ to x_{N}.

An i-th multiplexed modulated audio signal yᵢ (i = 1, 2, ..., M) generated by the signal modulator 3 is output to the signal line Lₕᵢ in the i-th row, and a j-th spreading code xⱼ (j = 1, 2, ..., N) is output to the signal line Lᵥⱼ in the j-th column. The (M × N) speakers obtain drive signals corresponding to the array control signals u₁₁ to u_{MN} by multiplying (correlating) the i-th multiplexed modulated audio signal yᵢ and the j-th spreading code xⱼ.

With respect to the multi-input ΔΣ modulation as described above, the signal modulator 3 performs the modulation only on a subset of audio signals among the plurality of channels carrying identical audio signals. Here, the signal modulator 3 determines which channels have identical audio signals according to the reproduction mode set by the reproduction mode switching unit 1, and determines which channel's audio signal is to be modulated. That is, the signal modulator 3 determines identical audio signals and the subset of the channels according to the array arrangement of the plurality of speakers and the type and position of the virtual sound source.

When virtually synthesizing wavefronts of a line sound source, a plane sound source, and a point sound source of a free sound field, the audio signals output from each speaker become identical audio signals only in which an amplitude and phase differ. For example, in the case of a plane wave in a front direction of the array from the virtual sound source, all speakers output the same audio signal. In the case of a point sound source, speakers having the same distance from the virtual sound source output the same audio signal.

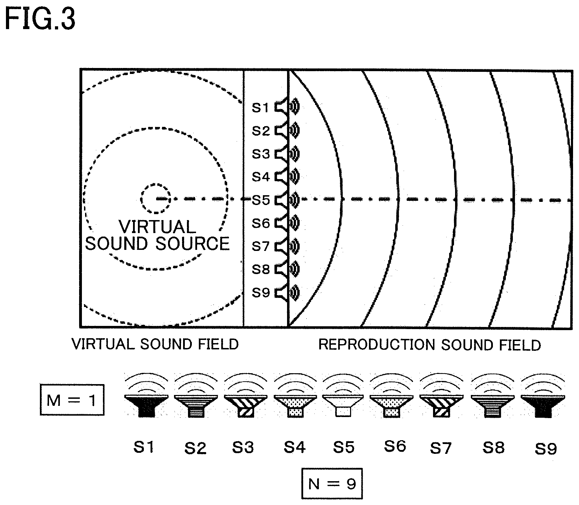

FIG. 3 is a drawing illustrating an example of speakers outputting the same audio signal. FIG. 3 shows an example of a line array arrangement where M = 1 and N = 9. As shown in FIG. 3, in the case of synthesizing the wavefront of the virtual point sound source, speakers S1 to S9 having nine channels are driven, but audio signals output from the speakers S1 and S9, the speakers S2 and S8, the speakers S3 and S7, and the speakers S4 and S6 having the same distance from the virtual point sound source are the same signals, so that it is practically possible to synthesize the wavefront if there are audio signals for five channels.

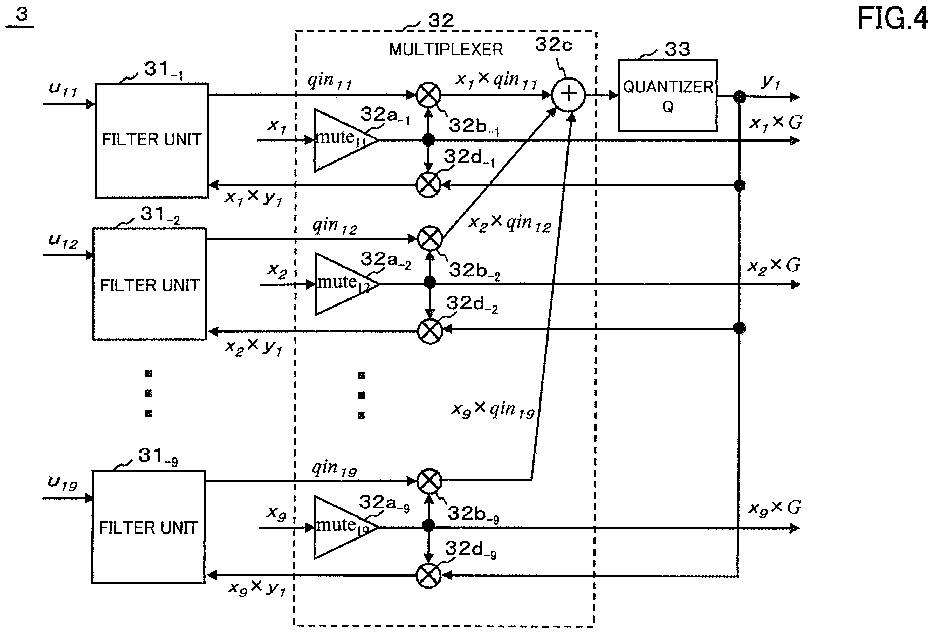

FIG. 4 is a drawing illustrating a configuration example of a signal modulator 3 according to an embodiment. Here, an example of the configuration of the signal modulator 3 in the case where nine speakers are arranged in a line array as shown in FIG. 3 where M = 1 and N = 9 is illustrated. As shown in FIG. 3, the signal modulator 3 includes filter units 31₋₁ to 31₋₉ (in the following, they may be collectively referred to as a filter unit 31) having a plurality of channels (here, nine channels), a multiplexer 32, and a quantizer 33.

The filter units 31₋₁ to 31₋₉ perform loop filter processing of ΔΣ modulation on each of the plurality of channels of audio signals (array control signals u₁₁ to u₁₉). That is, each of the filter units 31₋₁ to 31₋₉ includes a subtractor for obtaining a difference between a corresponding input signal (u₁₁ to u₁₉) and the signals x₁ × y₁ to x₉ × y₁ fed back from an output of the quantizer 33 via multipliers 32d₋₁ to 32d₋₉, and an integrator for integrating the difference.

The multiplexer 32 code-division multiplexes output signals of a subset of channels among the output signals (input signals to the quantizer 33) qin₁₁ to qin₁₉ of the filter units 31₋₁ to 31₋₉ using spreading codes of the corresponding channels. Specifically, the multiplexer 32 includes gain multipliers 32a₋₁ to 32a₋₉ that multiply each of spreading codes x₁ to x₉ of a plurality of channels by a corresponding gain; multiplier-adders 32b₋₁ to 32b₋₉ and 32c that, for each of the plurality of channels, multiply an output signal of the respective gain multipliers 32a₋₁ to 32a₋₉ by an output signal of the respective filter units 31₋₁ to 31₋₉, add the multiplication results to multiplex the channels; and the multipliers 32d₋₁ to 32d₋₉ described above on a feedback path.

Here, the multiplexer 32 controls gain G of the gain multipliers 32a₋₁ to 32a₋₉ to multiplex the output signals of a subset of channels of the filter units 31₋₁ to 31₋₉ using the spreading codes of the subset of channels. The gain G applied to the gain multipliers 32a₋₁ to 32a₋₉ is either 0 or 1. A gain multiplier 32a of the subset of channels corresponding to the audio signal to be multiplexed sets the gain G to 1, and the gain multiplier 32a of remaining channels corresponding to the audio signal not to be multiplexed sets the gain G to 0.

In the case of the line array arrangement shown in FIG. 3, for example, the gain G applied to the gain multipliers 32a₋₁ to 32a₋₅ of first to fifth channels is set to 1, and the gain G applied to the gain multipliers 32a₋₆ to 32a₋₉ of sixth to ninth channels is set to 0. In this case, the multiplexer 32 performs code division multiplexing on output signals qin₁₁ to qin₁₅ of the filter units 31₋₁ to 31-s of first to fifth channels using the spreading codes x₁ to x₅ of first to fifth channels.

Note that the gain G applied to the gain multipliers 32a₋₁ to 32a₋₄ of channels 1 to 4 may be set to 0, and the gain G applied to the gain multipliers 32a₋₅ to 32a₋₉ of channels 5 to 9 may be set to 1.

The quantizer 33 quantizes the output signal of the multiplexer 32 to generate a digital multiplexed modulated audio signal y₁.

The signal modulator 3 outputs to the drive signal generator 4 one multiplexed modulated audio signal y₁ generated by the quantizer 33 and the spreading codes x₁ × G to x₉ × G to which the gain G of "0" or "1" is applied by the gain multipliers 32a₋₁ to 32a₋₉. The spreading codes x₆ × G to x₉ × G of sixth to ninth channels to which the gain G of 0 is applied have a value of "0", which is equivalent to the fact that the spreading codes x₆ to x₉ are not output to the drive signal generator 4.

The drive signal generator 4 generates drive signals for driving the plurality of speakers corresponding to the plurality of channels including the subset of the channels and remaining channels, based on the multiplexed modulated audio signals generated from the audio signals by the signal modulator 3 and the spreading codes. When the signal modulator 3 is configured as shown in FIG. 4, the drive signal generator 4 generates drive signals for driving the plurality of speakers S1 to S9 corresponding to the first to ninth channels using the spreading codes x₁ to x₅ of the first to fifth channels and the multiplexed modulated audio signal y₁.

Here, the drive signal generator 4 generates the drive signals for driving nine speakers S1 to S9 corresponding to nine channels by assigning the spreading codes x₁ to x₄ of the first to fourth channels as common spreading codes x₁ to x₄ for the ninth to sixth channels corresponding to audio signals identical to those of the subset of the one or more channels. Since the number of the subset of the channels is odd, some of the spreading codes of the subset of the channels are assigned to remaining channels, but when the number of the subset of the channels is even, all the spreading codes of the subset of the channels are assigned to remaining channels.

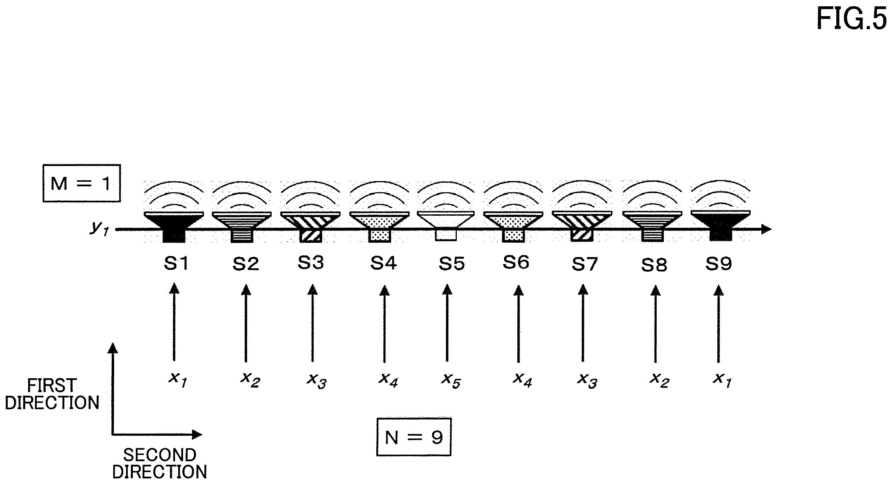

FIG. 5 is a drawing illustrating an example of drive signals for the speakers arranged in a line array as shown in FIG. 3. The drive signals are a multiplexed modulated audio signal y₁ output to one signal line in the first direction and nine spreading codes x₁ to x₅ and x₄ to x₁ output to nine signal lines in the second direction. Of the nine spreading codes x₁ to x₅ and x₄ to x₁ shown in FIG. 5, the spreading codes x₁ to x₅ in the first to fifth columns are spreading codes x₁ × G to x₅ × G (G = 1) output from the signal modulator 3. Alternatively, the spreading codes x₄ to x₁ in the sixth to ninth columns are spreading codes x₁ to x₄ in the first to fourth columns assigned by the drive signal generator 4 to channels outputting the same audio signals as those channels. That is, the drive signal generator 4 assigns the spreading code x₁ of the first column as the spreading code x₁ of the ninth column, the spreading code x₂ of the second column as the spreading code x₂ of the eighth column, the spreading code x₃ of the third column as the spreading code x₃ of the seventh column, and the spreading code x₄ of the fourth column as the spreading code x₄ of the sixth column.

Accordingly, since the multi-input ΔΣ modulation is performed only for the audio signals of some channels, the number of spreading codes used for demodulating the multiplexed modulated audio signals can be reduced in accordance with the reduced channels, and the above-described assignment can be performed.

As described above, in the audio processing apparatus, based on the audio signals (array control signals u₁₁ to u_{MN}) of (M × N) channels generated by the array control filter unit 2 corresponding to a total of (M × N) speakers arranged in an array of M speakers in the first direction and N speakers in the second direction, the signal modulator 3 and the drive signal generator 4 perform processing to generate (M + N) drive signals to be output to a total of (M + N) signal lines of M speakers in the first direction and N speakers in the second direction. In the case of the line array arrangement of the speakers S1 to S9 illustrated in FIG. 3, M = 1 and N = 9.

Here, the signal modulator 3 performs modulation and multiplexing on the audio signals of (M × N) channels, thereby outputting M multiplexed modulated audio signals generated from the audio signals of some channels and N' (N > N') spreading codes related to some channels. When the signal modulator 3 is configured as shown in FIG. 4 based on the line array arrangement of the speakers S1 to S9 illustrated in FIG. 3, N' = 5, and one multiplexed modulated audio signal y₁ and five spreading codes x₁ to x₅ generated from audio signals of the first to fifth channels are output.

Further, the drive signal generator 4 generates the drive signals for driving the plurality of speakers by assigning at least part of the N' spreading codes of the subset of the channels as common code information for the remaining channels based on N spreading codes after assignment and the M multiplexed modulated audio signals. In the case of the line array arrangement of the speakers S1 to S9 illustrated in FIG. 3, the drive signal generator 4 generates drive signals y₁, x₁ to x₅, x₄ to x₁ for driving the nine speakers S1 to S9 by assigning four spreading codes x₁ to x₄ of the first to fourth channels among five spreading codes subjected to modulation processing in the signal modulator 3 to be used in common as the spreading codes x₄ to x₁ of the ninth to sixth channels.

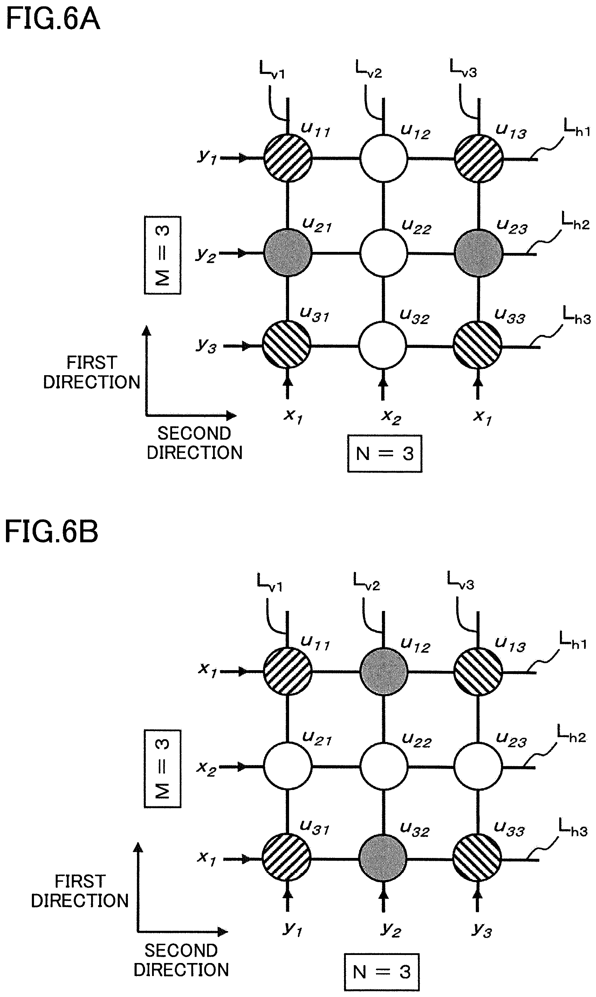

FIGS. 6A and 6B are drawings illustrating examples of drive signals for speakers arranged in a two-dimensional array (matrix arrangement) in the first direction and the second direction. FIG. 6A shows an example when M = 3, N = 3, and N' = 2. In the example shown in FIG. 6A, the same audio signal is output from the speakers at positions with the same type of hatching. Different audio signals are output from the speakers at positions without hatching. That is, array control signals u₁₁ and u₁₃ are the same audio signals, array control signals u₂₁ and u₂₃ are the same audio signals, and array control signals u₃₁ and u₃₃ are the same audio signals.

In the example shown in FIG. 6A, the signal modulator 3 applies ΔΣ modulation to three (N) array control signals u₁₁ to u₁₃, and performs code-division multiplexing on two (N') modulated outputs using two spreading codes x₁ to x₂, thereby generating a first multiplexed modulated audio signal y₁. The signal modulator 3 applies ΔΣ modulation to three array control signals u₂₁ to u₂₃, and performs code-division multiplexing on two modulated outputs using two spreading codes x₁ to x₂, thereby generating a second multiplexed modulated audio signal y₂. The signal modulator 3 applies ΔΣ modulation to three array control signals u₃₁ to u₃₃, and performs code-division multiplexing on two modulated outputs using two spreading codes x₁ to x₂, thereby generating a third multiplexed modulated audio signal y₃.

The drive signal generator 4 generates the drive signals for driving the nine speakers by assigning the spreading code x₁ in the first column associated with the subset of the channels as the common spreading code x₁ in the third column associated with the remaining channels corresponding to audio signals identical to those of the subset of the channels based on three (N) spreading codes x₁, x₂, and x₁ after assignment and three (M) multiplexed modulated audio signals y₁ to y₃.

FIG. 6B shows a two-dimensional array arrangement of the speakers shown in FIG. 6A in which the directions of the signal lines for outputting the spreading code x and the multiplexed modulated audio signal y are reversed. That is, in the case of FIG. 6A, multiplexed modulated audio signals y₁ to y₃ are output to signal lines Lₕ₁ to Lₕ₃ in the horizontal direction and spreading codes x₁, x₂, and x₁ are output to signal lines Lᵥ₁ to Lᵥ₃ in the vertical direction, whereas in the case of FIG. 6B, multiplexed modulated audio signals y₁ to y₃ are output to signal lines Lᵥ₁ to Lᵥ₃ in the vertical direction and spreading codes x₁, x₂, and x₁ are output to signal lines Lₕ₁ to Lₕ₃ in the horizontal direction. Only the directions in which the drive signals y₁ to y₃, x₁, x₂, and x₁ are output are different, and the processing of the signal modulator 3 and the drive signal generator 4 is the same in the case of FIG. 6A and the case of FIG. 6B.

According to the audio processing apparatus configured as described above, by performing multi-input ΔΣ modulation on audio signals of a plurality of channels using spreading codes, it is possible to suppress an increase in the number of signal lines and the circuit scale in the speaker array configuration. In addition, by reducing the number of channels and performing the processing of the signal modulator 3, and then returning the number of channels to the original number in the drive signal generator 4 and generating drive signals for a plurality of speakers, it is possible to suppress an increase in the noise floor and a decrease in the effective input amplitude due to multi-channel operation, thereby improving the S/N ratio.

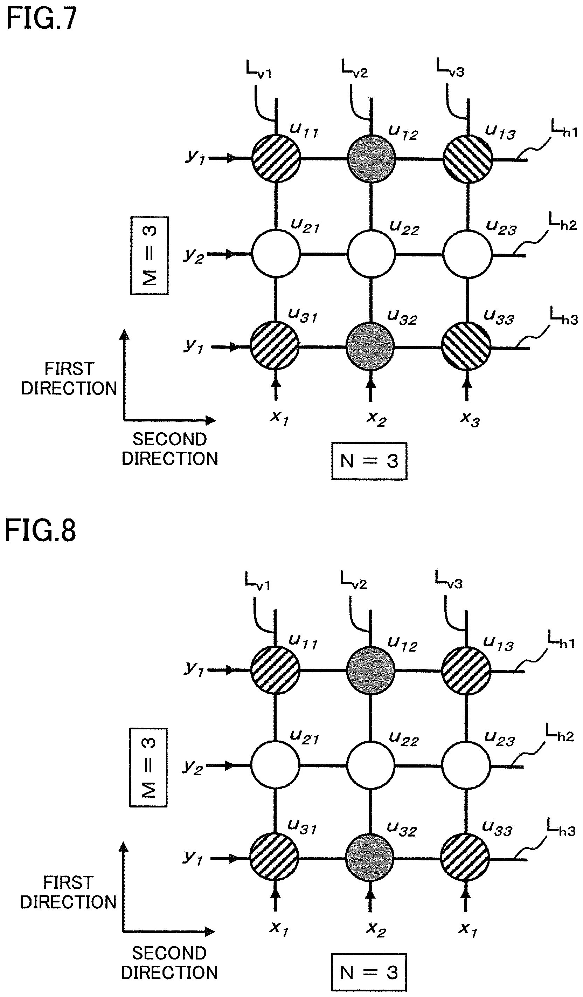

Note that in the above disclosure, an example has been described in which the number of spreading codes used in the signal modulator 3 is reduced, and the spreading codes of some channels are assigned in the drive signal generator 4 so as to be commonly used as the spreading codes of remaining channels, but the audio processing apparatus of the present disclosure is not limited to this. As shown in FIGS. 3 and 6, the above-described embodiments are suitable for a case in which part of the same audio signal output from speakers located at different positions is multiplexed into a single multiplexed modulated audio signal. Alternatively, as shown in FIG. 7, the audio processing apparatus of the present disclosure may also be applied to a case in which the same audio signal output from speakers located at different positions is included in another multiplexed modulated audio signal.

In the example shown in FIG. 7, the array control signal u₁₁ and the array control signal u₃₁ are the same audio signals, the array control signal u₁₂ and the array control signal u₃₂ are the same audio signals, and the array control signal u₁₃ and the array control signal u₃₃ are the same audio signals. In this case, the multiplexed modulated audio signal y generated from the array control signals u₁₁ to u₃₁ is the same as the multiplexed modulated audio signal y generated from the array control signals u₃₁ to u₃₃. Therefore, the multiplexed modulated audio signal y₁ of the first row is generated only from the array control signals u₁₁ to u₃₁ of a partial channel, and is assigned to be used in common as the multiplexed modulated audio signal y₁ of the third row generated from the array control signals u₃₁ to u₃₃ of the same remaining channels as the array control signals u₁₁ to u₃₁ of the partial channel, thereby generating a drive signal for driving a plurality of speakers corresponding to a plurality of channels.

That is, the signal modulator 3 performs multi-input ΔΣ modulation on the audio signals of the (M × N) channels (in FIG. 7, M = 3, N = 3), thereby outputting M' (M' = 2 in FIG. 7) multiplexed modulated audio signals y₁ and y₂ and N spreading codes x₁ to x₃ generated from the audio signals of the partial channel.

Further, the drive signal generator 4 generates the drive signals for driving the plurality of speakers by assigning at least part of the M' multiplexed modulated audio signals associated with the subset of the channels (the multiplexed modulated audio signal y₁ of the first row in FIG. 7) as the common multiplexed modulated audio signal y₁ of the third row generated from the audio signals of the remaining channels having audio signals identical to those of the subset of the one or more channels based on M multiplexed modulated audio signals y₁, y₂, and y₁, and N spreading codes x₁ to x₃ after assignment.

As shown in FIG. 8, it is also possible to apply a combination of assigning the spreading codes of the partial channel to be used in common as the spreading codes of the remaining channels and assigning the multiplexed modulated audio signals generated from the audio signals of the partial channel to be used in common as the multiplexed modulated audio signals generated from the audio signals of the remaining channels.

In the example shown in FIG. 8, four array control signals u₁₁, u₁₃, u₃₁, and u₃₃ are the same audio signals. In this case, the multiplexed modulated audio signal y of the first row generated from the array control signals u₁₁ to u₁₃ and the multiplexed modulated audio signal y of the third row generated from the array control signals u₃₁ to u₃₃ are the same signal. Further, the spreading code x in the first column and the spreading code x in the third column have the same code.

In such a configuration, the signal modulator 3 performs multi-input ΔΣ modulation on the audio signals of the (M × N) channels (in FIG. 8, M = 3, N = 3) to output M' (M' = 2 in FIG. 8) multiplexed modulated audio signals y₁ and y₂ generated from the audio signals of some channels and N' (N' = 2 in FIG. 8) spreading codes x₁ and x₂ related to some channels.

Further, the drive signal generator 4 generates the drive signals for driving the plurality of speakers by assigning at least part of the M' multiplexed modulated audio signals associated with the subset of the channels (the multiplexed modulated audio signal y₁ of the first row in FIG. 8) as the common multiplexed modulated audio signal y₁ of the third row generated from the audio signals of the remaining channels having audio signals identical to those of the subset of the one or more channels, assigning at least part of the N' multiplexed modulated audio signals associated with the subset of the channels (the multiplexed modulated audio signal x₁ of the first column in FIG. 8) as the common multiplexed modulated audio signal x₁ of the third column generated from the audio signals of the remaining channels having audio signals identical to those of the subset of the one or more channels, based on M multiplexed modulated audio signals y₁, y₂, and y₁, and N spreading codes x₁, x₂, and x₁ after assignment.

Further, in the above disclosure, an example in which the signal modulator 3 is configured as shown in FIG. 4 has been described, but the audio processing apparatus of the present disclosure is not limited thereto. For example, instead of the gain multiplier 32a, a selector for selecting either a spreading code or zero data may be used.

Further, in the above disclosure, a configuration in which the reproduction mode can be switched by the reproduction mode switching unit 1 has been described, but the audio processing apparatus of the present disclosure is not limited thereto. For example, the audio processing apparatus of the present disclosure can be applied to an audio system in which the arrangement of speakers and the type and arrangement of virtual sound sources are fixed, and in this case, the reproduction mode switching unit 1 can be omitted.

Further, in the above disclosure, a configuration in which the audio processing apparatus of the present disclosure includes the array control filter unit 2 has been described, but the present invention is not limited to this. For example, a configuration in which a device other than the audio processing apparatus of the present disclosure includes the array control filter unit 2 and the audio processing apparatus of the present disclosure inputs the array control signal u from the other device may be adopted.

Each of the configurations or processes described above can be appropriately combined and applied. Examples of configurations that can be applied to the described embodiments are summarized below.

### [Configuration 1]

An audio processing apparatus including:
a signal modulator configured to perform modulation and multiplexing only on a subset of audio signals of a plurality of channels generated in one-to-one correspondence with a plurality of speakers arranged in an array, one or more channels among the plurality of channels carrying identical audio signals, the subset of the audio signals including audio signals of only a subset of the one or more channels, and the multiplexing using predetermined code information; and
a drive signal generator configured to generate drive signals for driving the plurality of speakers corresponding to the plurality of channels including the subset of the one or more channels and remaining channels, based on the predetermined code information and multiplexed modulated audio signals generated from the subset of the audio signals by the signal modulator.

### [Configuration 2]

The audio processing apparatus according to configuration 1, wherein the drive signal generator is configured to generate the drive signals for driving the plurality of speakers corresponding to the plurality of channels by assigning code information of the subset of the one or more channels as common code information for the remaining channels corresponding to audio signals identical to those of the subset of the one or more channels.

### [Configuration 3]

The audio processing apparatus according to configuration 2, wherein:
the audio processing apparatus is configured to generate (M + N) drive signals for being output to (M + N) signal lines including M signal lines extending in a first direction and N signal lines extending in a second direction, by performing processing of the signal modulator and the drive signal generator based on the audio signals of (M × N) channels generated corresponding to a total of (M × N) speakers arranged in an array of M speakers in the first direction and N speakers in the second direction (M ≥ 1, N ≥ 1, where (M, N) ≠ (1, 1));
the signal modulator is configured to output:
   M multiplexed modulated audio signals generated from audio signals of the subset of the one or more channels; and
   $N ′ \left(N>N′\right)$ pieces of code information associated with the subset of the one or more channels,
   by performing modulation and multiplexing on the (M × N) channels of audio signals; and
the drive signal generator is configured to generate the drive signals for driving the plurality of speakers by assigning at least part of the N' pieces of code information of the subset of the one or more channels as the common code information for the remaining channels based on N pieces of code information after assignment and the M multiplexed modulated audio signals.

### [Configuration 4]

The audio processing apparatus according to one of configurations 1 to 3, wherein the drive signal generator is configured to generate the drive signals for driving the plurality of speakers corresponding to the plurality of channels by assigning the multiplexed modulated audio signals generated from the audio signals of the subset of the one or more channels as common multiplexed modulated audio signals generated from the audio signals of the remaining channels having audio signals identical to those of the subset of the one or more channels.

### [Configuration 5]

The audio processing apparatus according to configuration 4, wherein:
the audio processing apparatus is configured to generate (M + N) drive signals for being output to (M + N) signal lines including M signal lines extending in a first direction and N signal lines extending in a second direction, by performing processing of the signal modulator and the drive signal generator based on the audio signals of (M × N) channels generated corresponding to a total of (M × N) speakers arranged in an array of M speakers in the first direction and N speakers in the second direction (M ≥ 1, N ≥ 1, where (M, N) ≠ (1, 1));
the signal modulator is configured to output: $M ′ \left(M>M′\right)$ multiplexed modulated audio signals generated from audio signals of the subset of the one or more channels; and
   N pieces of code information,
   by performing modulation and multiplexing on the (M × N) channels of audio signals; and
the drive signal generator is configured to generate the drive signals for driving the plurality of speakers by assigning at least part of the M' multiplexed modulated audio signals associated with the subset of the one or more channels as the common multiplexed modulated audio signals for the remaining channels based on M multiplexed modulated audio signals after assignment and the N pieces of code information.

### [Configuration 6]

The audio processing apparatus according to configuration 2 or 4, wherein:
the audio processing apparatus is configured to generate (M + N) drive signals for being output to (M + N) signal lines including M signal lines extending in a first direction and N signal lines extending in a second direction, by performing processing of the signal modulator and the drive signal generator based on the audio signals of (M × N) channels generated corresponding to a total of (M × N) speakers arranged in an array of M speakers in the first direction and N speakers in the second direction (M ≥ 1, N ≥ 1, where (M, N) ≠ (1, 1));
the signal modulator is configured to output: $M ′ \left(M>M′\right)$ multiplexed modulated audio signals generated from audio signals of the subset of the one or more channels; and $N ′ \left(N>N′\right)$
   pieces of code information associated with the subset of the channels,
   by performing modulation and multiplexing on the (M × N) channels of audio signals; and
the drive signal generator is configured to generate the drive signals for driving the plurality of speakers by assigning:
   at least part of the M' multiplexed modulated audio signals associated with the subset of the one or more channels as common multiplexed modulated audio signals for the remaining channels; and
   at least part of the N' pieces of code information as the common code information for the remaining channels,
based on M multiplexed modulated audio signals and N pieces of code information after assignment.

### [Configuration 7]

The audio processing apparatus according to any one of configurations 1 to 6, wherein the signal modulator is configured to determine:
the identical audio signals; and
the subset of the one or more channels,
based on array arrangement of the plurality of speakers and a type and position of a virtual sound source.

### [Configuration 8]

The audio processing apparatus according to any one of configurations 1 to 7, wherein the signal modulator includes:
a filter unit configured to perform loop filter processing of ΔΣ modulation for each of the audio signals of the plurality of channels;
a multiplexer configured to multiplex output signals of the subset of the one or more channels among the output signals of the plurality of channels of the filter unit based on the code information of the subset of the one or more channels; and
a quantizer configured to quantize output signals of the multiplexer.

### [Configuration 9]

The audio processing apparatus according to configuration 2 or 3, wherein:
the signal modulator includes:
   a filter unit configured to perform loop filter processing of ΔΣ modulation for each of the audio signals of the plurality of channels;
   a multiplexer configured to multiplex output signals of the subset of the channels among the output signals of the plurality of channels of the filter unit based on the code information of the subset of the one or more channels; and
   a quantizer configured to quantize output signals of the multiplexer;
the multiplexer includes:
   gain multipliers configured to multiply the code information of the plurality of channels by respective gains; and
   a multiplier-adder configured to multiply an output of the gain multipliers by an output signal of the filter unit for each of the plurality of channels and to perform the multiplexing by adding multiplication results of the plurality of channels, and
the multiplexer is configured to multiplex the output signals of the subset of the one or more channels using the code information associated with the subset of the one or more channels by controlling gains of the gain multipliers.

Further, the present invention is not limited to these embodiments, and various variations and modifications may be made without departing from the scope of the claims.

## Claims

1. An audio processing apparatus comprising:
a signal modulator configured to perform modulation and multiplexing only on a subset of audio signals of a plurality of channels generated in one-to-one correspondence with a plurality of speakers arranged in an array, one or more channels among the plurality of channels carrying identical audio signals, the subset of the audio signals including audio signals of only a subset of the one or more channels, and the multiplexing using predetermined code information; and
a drive signal generator configured to generate drive signals for driving the plurality of speakers corresponding to the plurality of channels including the subset of the one or more channels and remaining channels, based on the predetermined code information and multiplexed modulated audio signals generated from the subset of the audio signals by the signal modulator.

2. The audio processing apparatus according to claim 1, wherein the drive signal generator is configured to generate the drive signals for driving the plurality of speakers corresponding to the plurality of channels by assigning code information of the subset of the one or more channels as common code information for the remaining channels corresponding to audio signals identical to those of the subset of the one or more channels.

3. The audio processing apparatus according to claim 2, wherein:
the audio processing apparatus is configured to generate (M + N) drive signals for being output to (M + N) signal lines including M signal lines extending in a first direction and N signal lines extending in a second direction, by performing processing of the signal modulator and the drive signal generator based on the audio signals of (M × N) channels generated corresponding to a total of (M × N) speakers arranged in an array of M speakers in the first direction and N speakers in the second direction (M ≥ 1, N ≥ 1, where (M, N) ≠ (1, 1));
the signal modulator is configured to output:
M multiplexed modulated audio signals generated from audio signals of the subset of the one or more channels; and
$N ′ \left(N>N′\right)$ pieces of code information associated with the subset of the one or more channels, by performing modulation and multiplexing on the (M × N) channels of audio signals; and
the drive signal generator is configured to generate the drive signals for driving the plurality of speakers by assigning at least part of the N' pieces of code information of the subset of the one or more channels as the common code information for the remaining channels based on N pieces of code information after assignment and the M multiplexed modulated audio signals.

4. The audio processing apparatus according to one of claims 1 to 3, wherein the drive signal generator is configured to generate the drive signals for driving the plurality of speakers corresponding to the plurality of channels by assigning the multiplexed modulated audio signals generated from the audio signals of the subset of the one or more channels as common multiplexed modulated audio signals generated from the audio signals of the remaining channels having audio signals identical to those of the subset of the one or more channels.

5. The audio processing apparatus according to claim 4, wherein:
the audio processing apparatus is configured to generate (M + N) drive signals for being output to (M + N) signal lines including M signal lines extending in a first direction and N signal lines extending in a second direction, by performing processing of the signal modulator and the drive signal generator based on the audio signals of (M × N) channels generated corresponding to a total of (M × N) speakers arranged in an array of M speakers in the first direction and N speakers in the second direction (M ≥ 1, N ≥ 1, where (M, N) ≠ (1, 1));
the signal modulator is configured to output: $M ′ \left(M>M′\right)$ multiplexed modulated audio signals generated from audio signals of the subset of the one or more channels; and
N pieces of code information,
by performing modulation and multiplexing on the (M × N) channels of audio signals; and
the drive signal generator is configured to generate the drive signals for driving the plurality of speakers by assigning at least part of the M' multiplexed modulated audio signals associated with the subset of the one or more channels as the common multiplexed modulated audio signals for the remaining channels based on M multiplexed modulated audio signals after assignment and the N pieces of code information.

6. The audio processing apparatus according to claim 2 or 4, wherein:
the audio processing apparatus is configured to generate (M + N) drive signals for being output to (M + N) signal lines including M signal lines extending in a first direction and N signal lines extending in a second direction, by performing processing of the signal modulator and the drive signal generator based on the audio signals of (M × N) channels generated corresponding to a total of (M × N) speakers arranged in an array of M speakers in the first direction and N speakers in the second direction (M ≥ 1, N ≥ 1, where (M, N) ≠ (1, 1));
the signal modulator is configured to output: $M ′ \left(M>M′\right)$ multiplexed modulated audio signals generated from audio signals of the subset of the one or more channels; and $N ′ \left(N>N′\right)$ pieces of code information associated with the subset of the channels,
by performing modulation and multiplexing on the (M × N) channels of audio signals; and
the drive signal generator is configured to generate the drive signals for driving the plurality of speakers by assigning:
at least part of the M' multiplexed modulated audio signals associated with the subset of the one or more channels as common multiplexed modulated audio signals for the remaining channels; and
at least part of the N' pieces of code information as the common code information for the remaining channels,
based on M multiplexed modulated audio signals and N pieces of code information after assignment.

7. The audio processing apparatus according to one of claims 1 to 6, wherein the signal modulator is configured to determine:
the identical audio signals; and
the subset of the one or more channels,
based on array arrangement of the plurality of speakers and a type and position of a virtual sound source.

8. The audio processing apparatus according to one of claims 1 to 7, wherein the signal modulator includes:
a filter unit configured to perform loop filter processing of ΔΣ modulation for each of the audio signals of the plurality of channels;
a multiplexer configured to multiplex output signals of the subset of the one or more channels among the output signals of the plurality of channels of the filter unit based on the code information of the subset of the one or more channels; and
a quantizer configured to quantize output signals of the multiplexer.

9. The audio processing apparatus according to claim 2 or 3, wherein:
the signal modulator includes:
a filter unit configured to perform loop filter processing of ΔΣ modulation for each of the audio signals of the plurality of channels;
a multiplexer configured to multiplex output signals of the subset of the channels among the output signals of the plurality of channels of the filter unit based on the code information of the subset of the one or more channels; and
a quantizer configured to quantize output signals of the multiplexer;
the multiplexer includes:
gain multipliers configured to multiply the code information of the plurality of channels by respective gains; and
a multiplier-adder configured to multiply an output of the gain multipliers by an output signal of the filter unit for each of the plurality of channels and to perform the multiplexing by adding multiplication results of the plurality of channels, and
the multiplexer is configured to multiplex the output signals of the subset of the one or more channels using the code information associated with the subset of the one or more channels by controlling gains of the gain multipliers.
